# EUROPÄISCHE PATENTSCHRIFT

(11) **EP 0 975 953 B1**
(45) Veröffentlichungstag und Bekanntmachung des Hinweises auf die Patenterteilung: **24.03.2004**
(21) Anmeldenummer: 97909127.9
(22) Anmeldetag: 09.09.1997
(51) Int. Cl.: G01N 23/04, G01R 31/302

(54) **VORRICHTUNG ZUR INSPEKTION VON TESTOBJEKTEN UND VERWENDUNG DER VORRICHTUNG**
DEVICE FOR INSPECTING TEST OBJECTS AND THE USE THEREOF
DISPOSITIF DE CONTROLE D'OBJETS A TESTER ET SON UTILISATION

(30) Priorität: 14.04.1997 DE 19715502
(43) Veröffentlichungstag der Anmeldung: 02.02.2000
(73) Patentinhaber: Fraunhofer-Gesellschaft zur Förderung der angewandten Forschung e.V., 80686 München (DE); Grohmann, Christoph, 53945 Blankenheim (DE)
(72) Erfinder: GROHMANN, Christoph,Dipl.-Ing., D-53945 Blankenheim (DE); HANKE, Randolf,Dr.-Ing., D-90766 Fürth (DE); HAFER, Detlef,Dipl.-Ing., D-90427 Nürnberg (DE)
(86) Internationale Anmeldenummer: PCT/DE1997/002024
(87) Internationale Veröffentlichungsnummer: WO 1998/046982

(56) Entgegenhaltungen:
- EP-A- 0 683 389
- EP-B- 0 236 001
- US-A- 5 097 492
- US-A- 5 259 012
- US-A- 5 463 667
- US-A- 5 621 811

## Beschreibung

Die vorliegende Erfindung bezieht sich auf eine Vorrichtung zur Inspektion von Testobjekten mit den Merkmalen des Oberbegriffs von Anspruch 1 sowie auf die Verwendung der Vorrichtung zur Röntgen-Inspektion von Lötverbindungen auf Flachbaugruppen bzw. bestückten Leiterplatten und insbesondere auf die Verwendung der Vorrichtung zur vollautomatischen 100%-Röntgen-Inspektion von Lötverbindungen auf Flachbaugruppen bzw. bestückten Leiterplatten.

Eine Vorrichtung mit den Merkmalen des Oberbegriffs von Anspruch 1 ist aus der Europäischen Patentschrift Nr. 0 236 001 B1 bekannt. In dieser Patentschrift werden Systeme zur zweidimensionalen vollautomatischen Röntgen-Inspektion von Schaltplatten bzw. Leiterplatten beschrieben. Da die verwendete Röntgenquelle und der Röntgendetektor ein im Vergleich zur horizontalen Ausdehnung des zu prüfenden Bereichs des Testobjekts kleines Gesichtsfeld aufweisen, wird die Untersuchung des gesamten zur prüfenden Bereichs des Testobjekts durchgeführt, indem das Testobjekt entlang der x-y-Ebene verschoben wird. Das bekannte System weist somit ein Mehrfachachsen-Positioniersystem auf, um Leiterplatten aufzunehmen und sie geeignet zu positionieren.

Das bekannte System weist jedoch folgende Nachteile auf. Zum einen ist das Mehrfachachsen-Positioniersystem aufwendig konzipiert, da zusätzlich zu den XY-Verfahrachsen Einrichtungen zur Aufnahme und zum Ausschleusen der Leiterplatte eingebracht werden müssen. Da sich das Testobjekt zwischen Röntgenquelle und - detektor befindet, muß sich das entsprechende Positioniersystem auch in dem Zwischenraum zwischen Röntgenquelle und -detektor befinden. Somit verbraucht es viel Platz, so daß die gesamte Vorrichtung voluminös wird. Desweiteren werden bei der Bewegung der Leiterplatten bei hohen Beschleunigungen aufgrund der seitlich wirkenden Kräfte die Bauteile und insbesondere die Lötverbindungen belastet. Davon sind besonders hohe Teileaufbauten aber auch Bauteile, die aufgrund ihrer Bauform nur gering benetzte Lötstellen zulassen, betroffen.

Durch diese Belastung können die Lötverbindungen geschädigt werden. Dabei muß eine solche Schädigung gar nicht unmittelbar nach dem Beschleunigungs- oder Abbremsvorgang sichtbar zutage treten. Es ist ebenso denkbar, daß direkt nach dem Beschleunigungs- oder Abbremsvorgang eine nicht wahrnehmbare Beeinträchtigung der Lötstelle auftritt, die erst nach längerer Zeit, beispielsweise auch in Zusammenhang mit Temperaturschwankungen oder Vibrationen zu einem Ausfall der Lötstelle führt.

Ein weiterer Nachteil des bekannten Systems besteht darin, daß es nur zur zweidimensionalen Untersuchung von Testobjekten geeignet ist. Es ist nicht dafür ausgelegt, einzelne Bauteile auf der Leiterplatte dreidimensional zu untersuchen.

Desweiteren tritt das Problem auf, daß, wenn Leiterplatten mit stark unterschiedlichen Massen untersucht werden sollen, jeweils unterschiedliche Kräfte angelegt werden müssen, um sie innerhalb der vorgegebenen Zykluszeit zu bewegen. Entsprechend ist für jede Leiterplattensorte eine genaue Einstellung der Betriebsparameter erforderlich.

Darüber hinaus verursacht eine Bewegung der Leiterplatte während des Prüfprozesses einen Auf- und Abschwingvorgang der Leiterplatte. Folglich sind daher Wartezeiten zum Ausschwingen nötig, und Abstandsmessungen zur Leiterplatten können nicht mit sehr großer Genauigkeit durchgeführt werden. Desweiteren führt das Schwingungsverhalten der Leiterplatte während der langen Belichtungszeit der Kamera (> 200 ms) zu einer nichtoptimalen Bildschärfe.

Das Problem einer koordinierten Relativbewegung zwischen Testobjekt, Röntgenquelle und Detektor ist darüber hinaus in zahlreichen Patentschriften, die sich auf Verbesserungen von Tomosyntheseverfahren beziehen, diskutiert worden.

Bei der Tomosynthese handelt es sich um ein dreidimensionales Röntgen-Bildgebungsverfahren, bei dem eine Vielzahl von Röntgenaufnahmen bei verschiedenen Relativpositionen zwischen Testobjekt und Röntgenquelle bzw. - detektor aufgenommen werden, um die Querschnittsabbildung einer gewünschten Ebene innerhalb des dreidimensionalen Objekts auf dem Detektor zu bilden. Im Gegensatz dazu wird bei dem gattungsbildenden Röntgen-Inspektionssystem das Problem behandelt, bei einem einfachen Röntgen-Durchstrahlungsverfahren ohne Schichtauflösung den gesamten zu prüfenden Bereich eines Testobjekts mit einer Röntgenquelle und einem Detektor zu erfassen, die jeweils ein im Vergleich zur horizontalen Ausdehnung des zu prüfenden Bereichs des Testobjekts kleines Gesichtsfeld aufweisen.

Die bekannten Tomosyntheseverfahren, die beispielsweise aus den Veröffentlichungen von S. F. Buchele, H. Ellinger, F. Hopkins, in Materials Evaluation 48, Mai 1990; R. J. Kruse, R. H. Bossi in Review of Progress in Quantitative Nondestructive Evaluation Vol. 10B, 1991; D. G. Grant in IEEE Transactions on Biomedical Engineering 19, Jan. 1972; U. E. Ruttimann, X. Qi, L. Weber in Medical Physics 16(3), May/June 1989 bekannt sind, beruhen auf dem Prinzip, daß Röntgenstrahlenröhre und Detektor verschoben werden, während das zu untersuchende Objekt ortsfest bleibt. Da die hochgenaue Positionierung von Röntgenstrahlenröhre zahlreiche Probleme hinsichtlich dem einzuhaltenden Genauigkeitsgrad und der Geschwindigkeit des Meßverfahrens mit sich gebracht haben und einen komplizierten mechanischen Aufbau des Meßsystems bedingt haben, haben sich nachfolgende Untersuchungen auf eine weitere Vereinfachungen des Meßsystems, auf einen höheren Genauigkeitsgrad und eine erhöhte Meßgeschwindigkeit gerichtet.

So wird in der Deutschen Patentanmeldung P 42 35 183, die von einer Mitanmelderin der vorliegenden Anmeldung eingereicht worden ist, ein Verfahren zur Erzeugung von Schichtaufnahmen eines dreidimensionalen Objekts beschrieben, bei dem die Röntgenstrahlenquelle und der Detektor ortsfest bleiben, während das Objekt bewegt wird.

Ein ähnliches Verfahren ist aus der Europäischen Patentanmeldung EP-A-0 683 389 bekannt, in der ein laminographisches Untersuchungssystem mit einer Strahlungsquelle, einer Sensorvorrichtung und einer Vorrichtung zum Bewegen des Testobjekts beschrieben wird. Das Testobjekt wird bewegt, so daß es eine Vielzahl verschiedener Positionen zwischen Strahlungsquelle und Sensorvorrichtung einnimmt. Alternativ können auch Strahlungsquelle und Sensorvorrichtung auf einer Kreisbahn bewegt werden. In beiden Fällen muß jedoch das Testobjekt zur Inspektion sämtlicher Inspektionsbereiche relativ zu Strahlungsquelle und Sensorvorrichtung verschoben werden.

Weitere Konzepte zur Lösung der vorstehend genannten Probleme beruhen auf einer Realisierung der Röntgenstrahlenröhre, bei denen der die Röntgenstrahlung hervorrufende Elektronenstrahl durch Ablenkspulen abgelenkt wird.

So wird in der US-Patentschrift Nr. 5 097 492 ein tomographisches Untersuchungssystem beschrieben, bei dem der Elektronenstrahl durch entsprechend angesteuerte Ablenkspulen dergestalt abgelenkt wird, daß der dadurch entstehende Röntgenstrahl eine Kreisbewegung auf dem zu untersuchenden Objekt ausführt, um dadurch die für das Tomosyntheseverfahren notwendigen Querschnittsabbildungen zu erzielen.

Desweiteren wird in der US-Patentschrift Nr. 5 259 012 ein weiteres tomographisches Untersuchungssystem beschrieben, bei dem der Elektronenstrahl infolge der koordinierten Ablenkung durch Ablenkspulen einerseits eine Kreisbewegung auf dem Targetmaterial ausführt, so daß der dadurch entstehende Röntgenstrahl eine Kreisbewegung auf dem zu untersuchenden Objekt ausführt, um dadurch die für das Tomosyntheseverfahren notwendigen Querschnittsabbildungen zu erzielen. Zum anderen wird aber auch noch eine zusätzliche Gleichspannung an die Ablenkspule in X- oder Y-Richtung angelegt, so daß der resultierende Röntgenstrahl innerhalb der X-Y-Ebene geschwenkt wird und das Gesichtsfeld des Röntgenfokus innerhalb der Röntgenquelle verschiebbar ist.

Bei der Anwendung des in der US-Patentschrift Nr. 5 259 012 beschriebenen Mechanismus auf die Untersuchung des gesamten zu prüfenden Bereichs eines Testobjekts ergibt sich jedoch das Problem, daß die horizontale Ausdehnung der Röntgenröhre größer als der zu prüfende Bereich des Testobjekts sein muß. Dies führt einerseits zu einem sehr voluminösen Untersuchungssystem und führt darüber hinaus zu Problemen, wenn Testobjekte mit sehr verschieden großen zu prüfenden Bereichen verwendet werden. Darüber hinaus tritt das Problem auf, daß, da ja letztlich die Röntgenquelle jeweils gekippt und nicht verschoben wird, der Strahldurchmesser des Röntgenstrahls auf der Leiterplatte je nachdem, ob gerade ein zentraler Teil oder ein Randteil der Leiterplatte untersucht wird, variiert. Folglich schwankt ohne eine elektronische Nachregelung des Röntgenfokus die Genauigkeit der Messung.

Ein weiterer Nachteil dieses System besteht darin, daß, da die Ablenkspulen entsprechend gesteuert werden müssen, eine aufwendige und komplizierte Steuerung der Röntgenröhre notwendig ist.

Der vorliegenden Erfindung liegt somit die Aufgabe zugrunde, die aus der Europäischen Patentschrift Nr. 0 236 001 B1 bekannte Vorrichtung zur Inspektion von Testobjekten derart weiterzubilden, daß sie kompakter wird und schneller und tatsächlich zerstörungsfrei eine Untersuchung des gesamten zu prüfenden Bereichs des Testobjekts ermöglicht.

Gemäß der vorliegenden Erfindung wird die Aufgabe durch die kennzeichnenden Merkmale von Patentanspruch 1 gelöst. Gemäß der vorliegenden Erfindung wird darüber hinaus die Verwendung der erfindungsgemäßen Vorrichtung nach Anspruch 10 bereitgestellt. Die bevorzugten Ausführungsformen sind Gegenstand der Unteransprüche.

Die vorliegende Erfindung beruht auf der überraschenden Erkenntnis, daß es - im Gegensatz zu der im vorliegenden Anwendungsgebiet weitverbreitet herrschenden Meinung - möglich ist, die Röntgenstrahlenröhre trotz ihrer großen Masse, die ungefähr 10 bis 20 kg beträgt, innerhalb der X-Y-Ebene mit hoher Genauigkeit, das heißt mit einer Genauigkeit von bis zu ungefähr 5 µm, und hoher Geschwindigkeit zu verschieben.

Dies ist zum einen dadurch möglich, daß eine gewichtsärmere Röntgenstrahlenröhre ohne Vakuumpumpe und ohne Kühlung verwendet wird. Eine solche Röntgenstrahlenröhre kann in zufriedenstellender Weise verwendet werden, da für die Zwecke der vorliegenden Erfindung - wie nachstehend noch erklärt werden wird - eine Röntgenröhre mit einem größeren Brennfleckdurchmesser von größer als 10 µm, vorzugsweise bis zu 40 µm verwendet werden kann.

Desweiteren wird bei der Bewegung der Röntgenstrahlenröhre nur die Röntgenröhre selbst und das Hochspannungselement, das die Spannungsversorgung enthält, bewegt, während die Steuerungsvorrichtung zur Veränderung der Betriebsspannung oder -leistung nicht bewegt wird. Dennoch beträgt die Gesamtmasse der zu bewegenden Teile ca. 13,5 kg.

Zum anderen wurde durch die Erfinder der vorliegenden Erfindung eine spezielle Vorrichtung zum horizontalen Verschieben der Röntgenstrahlenröhre und auch des Detektors entwickelt, um sicherzustellen, daß diese Komponenten trotz ihrer großen Masse mit großer Genauigkeit und hoher Geschwindigkeit bewegt werden können. Diese spezielle Vorrichtung beruht auf einer geeigneten Kombination aus höchstpräzisen Achsenkomponenten, Meßsystemen und einer leistungsstarken Positioniersteuerung.

Durch die erfindungsgemäße Vorrichtung sind somit die folgenden Vorteile erzielbar:
1. Die erfindungsgemäße Vorrichtung ermöglicht eine vollständig zerstörungsfreie Prüfung der zu prüfenden Bereiche. Genauer gesagt werden in der erfindungsgemäßen Vorrichtung große Beschleunigungen der Leiterplatte vermieden, so daß aufgrund von Beschleunigungs- oder Abbremsvorgängen der Leiterplatten keine Beeinträchtigung der Lötstellen auftritt. Darüber hinaus ist es nicht notwendig, die Leiterplatten innerhalb der Halterung so zu fixieren, daß sie beim Beschleunigen/Abbremsen nicht verrutschen. Der Nachteil einer solchen Fixierung besteht nämlich darin, daß auch infolge der Fixierung die Leiterplatten im Randbereich, insbesondere die Leiterbahnen, die sich im Randbereich befinden, beeinträchtigt werden können, beispielsweise, wenn die Leiterplatten in eine Halterung eingeklemmt werden. Als weiterer Nachteil birgt die Fixierung die Gefahr, daß die Leiterplatten durch die großen Kräfte beim Beschleunigen oder Abbremsen in der Halterung verrutschen können, wodurch eine Schädigung der Leiterbahnen im Randbereich verursacht werden kann und der Inspektion durch Lageveränderung abgebrochen werden muß.
   Da bei der vorliegenden Erfindung die Leiterplatten keine Beschleunigungs- oder Abbremsvorgänge auffangen müssen, wird diese Gefahr sicher vermieden.
2. Desweiteren können Abstandsmessungen bei der ortsfesten Position der zu untersuchenden Leiterplatte mit erhöhter Genauigkeit durchgeführt werden, beispielsweise durch ein Laser-Triangulationsverfahren.
3. Da immer Komponenten mit konstanter Masse bewegt werden, nämlich die Röntgenstrahlenquelle und der Detektor ist im Gegensatz zu der bekannten Vorrichtung keine Anpassung des Verschiebungsmechanismus an die jeweils zu untersuchende Leiterplatte notwendig. Dadurch wird eine erhöhte Genauigkeit, eine größere Schnelligkeit sowie eine größere Flexibilität bei der Untersuchung von Leiterplatten mit jeweils verschiedenen Massen bewirkt.
4. Durch die wesentlich geringeren Bewegungsfreiräume erreicht die Bauweise der erfindungsgemäßen Vorrichtung wesentlich weniger Platzbedarf gegenüber herkömmlichen Vorrichtungen.
5. Die Zykluszeiten für die einzelnen Inspektionsschritte beinhalten keine inaktiven Wartezeiten, die sonst zum Ausschwingen der bewegten Baugruppenmassen erforderlich sind. Darüber hinaus wird die Zykluszeit auch nicht durch eine einzuhaltende Höchstbeschleunigung oder -verzögerung beeinträchtigt.
6. Hohe Bauteile und solche mit ungünstigem Schwerpunkt stellen kein Problem in Bezug auf die mechanische Festigkeit der Lötverbindungen dar.
6. Im Vergleich zu der aus der US-Patentschrift Nr.5 259 012 bekannten Vorrichtung ist die Bandbreite der zu untersuchenden Leiterplatten größer. Beispielsweise können mit einer erfindungsgemäßen Vorrichtung Baugruppen mit einer Länge im Bereich von 70 bis 500 mm, einer Breite im Bereich von 50 bis 500 mm, einer Leiterplattendicke von 0,5 bis 3 mm untersucht werden, ohne vorher größere Anpassungen der Meßgeometrie vorzunehmen. Desweiteren sind mit der erfindungsgemäßen Vorrichtung Inspektionen auf einer Inspektionsfläche von 500 x 500 mm möglich, wobei ein pro Untersuchung inspiziertes Prüffenster eine Größe von ca. 6,2 cm² hat.
7. Gemäß der vorliegenden Erfindung kann eine handelsübliche Mikrofokus-Röntgenröhre mit einem Brennfleckdurchmesser von ca. 20 bis 40 µm verwendet werden. Es ist keine große und aufwendige Röntgenröhre wie beispielsweise in der in der US-Patentschrift Nr. 5 259 012 beschriebenen Vorrichtung notwendig, und es ist auch keine komplizierte Steuerung einer solchen Röntgenröhre erforderlich. Darüber hinaus sind für die gemäß der vorliegenden Erfindung verwendete Röntgenstrahlenröhre keine Vakuumpumpe und keine Kühlung erforderlich.
8. Wie nachstehend noch anhand eines Beispiels erläutert werden wird, ist es mit Hilfe der erfindungsgemäßen Vorrichtung auch möglich, einzelne Bauteile einer Flachbaugruppe dreidimensional zu untersuchen.

Damit der Röntgenstrahlendetektor leicht verschoben werden kann, weist er vorzugsweise eine geringe Masse auf. Gemäß einer bevorzugten Ausführungsform ist der Röntgenstrahlendetektor ein sehr hochauflösender Taper, auf dem ein hochauflösender CCD-Chip aufgebracht ist. Zur Umwandlung der empfangenen Röntgenstrahlung in sichtbares Licht umfaßt der Detektor ferner einen Szintillator. Gemäß der vorliegenden Erfindung ist der Detektor vorzugsweise ein Detektor mit hoher Auflösung, d.h. bei einer Größe von 35 mm x 35 mm weist er ungefähr 1000 x 1000 Pixel auf. Aufgrund seiner hohen Auflösung kann der Detektor direkt unter der Baugruppe mit einem Abstand, der ungefähr 5 cm nicht überschreitet, angeordnet sein. Dadurch wird der auf das Prüfobjekt einfallende Röntgenstrahlendurchmesser in nur geringem Ausmaß vergrößert. Aufgrund der hohen Auflösung des Detektors wird dadurch jedoch die Genauigkeit der Inspektion nicht beeinträchtigt. Durch Verwendung dieses speziellen Detektors läßt sich die erfindungsgemäße Vorrichtung noch kompakter gestalten.

Aufgrund dieser Konstruktion ist es nicht erforderlich, daß die Röntgenstrahlenquelle einen Röntgenstrahl nur mit einem kleinen Brennfleckdurchmesser emittiert. Erfindungsgemäß führen Mikrofokusröhren mit einem Brennfleckdurchmesser von ungefähr 20 µm bis 40 µm zu zufriedenstellenden Bildschärfen. Die Verwendung von Röntgenstrahlenröhre mit vergrößerten Brennfleckdurchmessern ist vorteilhaft, da solch eine Röntgenstrahlenröhre mehr Photonen emittiert und dadurch ein besseres S/N-Verhältnis und eine bessere Bildqualität bewirkt.

Gemäß der vorliegenden Erfindung werden bei der Bewegung der Röntgenstrahlenquelle die Röntgenröhre selbst und das Hochspannungselement, das die Spannungsversorgung zur Bereitstellung der Röntgenbeschleunigungsspannung, die sich typischerweise innerhalb eines Bereichs von einigen 10 bis 100 kV befindet, enthält, bewegt, während die Steuerungsvorrichtung zur Veränderung der Betriebsspannung oder der Leistung statisch fest im Schaltschrank untergebracht ist.

Dadurch, daß die Röntgenstrahlenröhre und der Detektor, die ja bei jeder Messung dieselben Komponenten sind, bewegt werden, muß die Anpassung der Verschiebungskomponenten für die Röntgenstrahlenröhre und den Detektor nur einmal erfolgen. Die Anpassung erfolgt nach bekannten Kalibrierungsverfahren.

Die vorliegende Erfindung wird im folgenden unter Bezugnahme auf die begleitenden Zeichnungen detaillierter beschrieben.

Fig. 1 zeigt eine schematische Darstellung der erfindungsgemäßen Vorrichtung zur Erläuterung des Prinzips der Erfindung.

Fig. 2 zeigt die Anwendung der erfindungsgemäßen Vorrichtung zur Aufnahme von Schrägprojektionen bei der Anwendung auf die dreidimensionale Auswertung der Testobjekte.

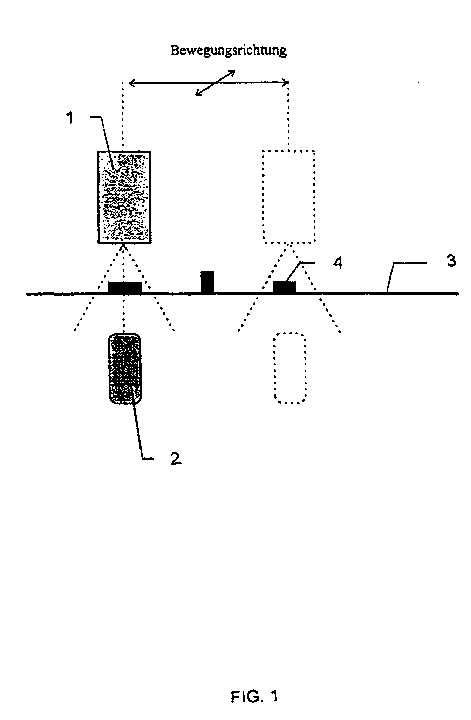

Fig. 1 stellt eine schematische Darstellung einer ersten Ausführungsform der vorliegenden Erfindung dar. In Fig. 1 bezeichnet Bezugszeichen 1 eine Röntgenstrahlenröhre, Bezugszeichen 2 bezeichnet einen Röntgenstrahlen-Detektor, Bezugszeichen 3 bezeichnet eine zu untersuchende, mit Bauteilen 4 bestückte Leiterplatte. Die Röntgenstrahlenröhre ist an einer beweglichen Halterung montiert und kann in X- und in Y-Richtung verfahren werden.

Die in Fig. 1 gezeigte Vorrichtung wird als Beispiel zur vollautomatischen 100%-Röntgen-Inspektion von Lötverbindungen auf Flachbaugruppen bzw. bestückten Leiterplatten eingesetzt.

Die Leiterplatte 3 wird auf einer Halterung befestigt und so langsam in die Untersuchungskammer eingefahren, daß die während dieses Vorgangs wirkenden Kräfte keine Beeinträchtigungen der Lötstellen nach sich ziehen. Dann wird die Leiterplatte 3 ortsfest positioniert, so daß sie während der Lötstelleninspektion nicht mehr bewegt wird. Zur Aufnahme eines beliebigen Leiterplattenausschnitts in dem zu überprüfenden Bereich werden die Röntgenstrahlenröhre 1 und der Detektor 2 in X- und in Y-Richtung parallel zueinander verfahren. Die Detektoreinheit 2 umfaßt ein nicht gezeigtes Kamerasystem. Während des Prüfvorgangs wird der entsprechende Bereich der Leiterplatte 3 mit Röntgenstrahlen durchleuchtet, und die absorbierten Röntgenstrahlen werden durch den Detektor in sichtbares Licht umgewandelt. Mit Hilfe eines Kamerasystems wird das Röntgenbild aufgenommen und einer Recheneinheit zur Auswertung übertragen.

Zu Beginn der Lötstellenprüfung werden die Bestückdaten der Leiterplatte eingelesen. Die Bestückdaten (CAD-Daten) definieren, welches Bauteil an welcher Position in welchem Drehwinkel positioniert ist. Aufgrund dieser Information läßt sich unter Berücksichtigung der Objektauflösung für jedes aufgenommene Röntgenbild genau feststellen, wo eine Lötstelle eines Bauteils im Röntgenbild abgebildet wird.

In der Recheneinheit werden mit Hilfe der zugrundeliegenden CAD-Daten die im Bild vorkommenden Lötstellen "herausgeschnitten" und anschließend der Bildauswerteeinheit zugeführt.

Dabei befinden sich abhängig von der Bestückdichte einer Leiterplatte nicht selten einige tausend Lötstellen auf jedem Nutzen einer Leiterplatte. Theoretisch müßte der Techniker, der das Prüfprogramm für diese Baugruppe erstellt, nun jede einzelne Lötstelle mit Prüfparametern versehen. Diese interaktive Eingabe ist nicht nur zeitaufwendig sondern auch sehr fehleranfällig. Besonders ist es sehr schwierig, die richtigen Einstellungen (Toleranzen, Schwellen usw.) zu finden, die einen minimalen Pseudo-Schlupfanteil garantieren. Daher wird gemäß eine bevorzugten Ausführungsform der vorliegenden Erfindung das System so trainiert, daß es sich die Parameter selbst findet, was deutlich Zeit spart und keine Interaktion des Benutzers erfordert. Bei dieser Ausführungsform ist die Schwellen-/Toleranzenfindung sehr dicht an der Realität und wird nur an einigen wenigen Stellen durch den Benutzer nachgebessert.

Gemäß dieser bevorzugten Ausführungsform liegen somit für die nachfolgende Bildauswertung zwei Modi zur Lötstelleninspektion vor.

### Lernmodus

Mit dem Bildpuffer wird ein Satz von anzuwendenden Prüfalgorithmen an die Bildauswerteeinheit übergeben. Mit Hilfe dieser Algorithmen wird ein Merkmalsvektor für die individuelle Lötstelle generiert. Dieser Merkmalsvektor beschreibt nur die und keine andere Lötstelle gleichen Typs. Dieser Merkmalsvektor wird mit den Vektoren derselben Lötstelle von weiteren Platinen optimiert, so daß man im Idealfall nach mehreren untersuchten fehlerfreien Lötstellen einen Merkmalsvektor generiert hat, der eine fehlerfreie Lötstelle statistisch repräsentiert. Dieser Merkmalsvektor kann pad- und bauteilbezogen in eine Prüfdatenbank abgelegt werden, so daß der Einlernvorgang bei neu zu untersuchenden Platinen mit Bauteilen gleichen Typs eingespart werden kann. In der baugruppenspezifischen Leiterplattendatei werden diese Vektoren ebenfalls abgelegt.

### Prüfmodus

Im Prüfmodus werden der Bildauswerteeinheit der Pad-Bildpuffer, der Satz an Prüfalgorithmen und die eingelernten Merkmalsvektoren mit Toleranzen übergeben.

Wenn der gewonnene Merkmalsvektor mit dem eingelernten Vektor innerhalb der vorgegebenen Toleranzen korreliert, so ist die Lötstelle als fehlerfrei einzustufen, andernfalls ist sie als fehlerhaft einzustufen.

Dabei ist der Satz an Prüfalgorithmen nicht fest vorgegeben, und er muß nicht bauteilbezogen eingeschränkt werden. Der Anwender kann auch frei neue Algorithmen in das System aufnehmen und sie je nach Bedarf zur Inspektion hinzuziehen oder herausnehmen.

Durch das verwendete Prüfungsverfahren können die folgenden Fehler an Baugruppen lokalisiert werden: Zum einen eine fehlerhafte Lötqualität wie beispielsweise Lunker, Ausbläser, Einsackungen, keine bzw. schlechte Benetzung von Bauteilen, fehlender Kontakt am Bauteil, Lotmenge zu groß bzw. zu klein, Lotbrücke (Kurzschluß), Zinnperlen und sonstige Zinnreste (z. B. zwischen Leiterbahnen oder Anschlüssen) und zum anderen mangelhafte Bestückqualität wie beispielsweise fehlendes Bauteil, Bauteil verdreht oder versetzt, Bauteil steht hoch, Beinchen verbogen oder versetzt. Die untersuchbaren Bauteiltypen sind THT ("Through Hole Technology"), SMD ("Surface Mounted Devices") und BGA ("Ball Grid Array").

Zur Aufnahme eines weiteren Leiterplattenausschnitts in dem zu überprüfenden Bereich werden die Röntgenstrahlenröhre 1 und der Detektor 2 erneut in X- und in Y-Richtung parallel zueinander verfahren, während die Leiterplatte ortsfest positioniert bleibt. Diese Vorgänge werden solange durchgeführt, bis der gesamte zu überprüfende Bereich der Leiterplatte 3 untersucht worden sind. Dabei erfolgt die Lageerkennung der einzelnen Leiterplattenausschnitte jeweils durch eine automatische Auswertung der Positionen von Paßmarken und/oder Durch konta ktierungen.

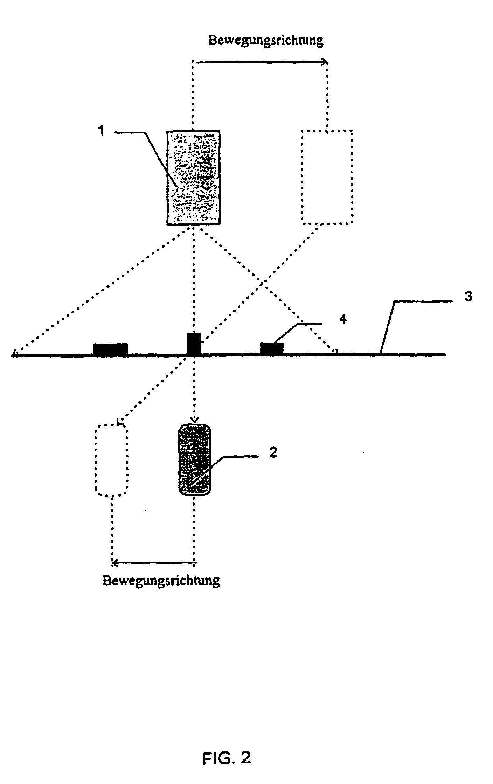

Es ist bei der erfindungsgemäßen Vorrichtung auch möglich, die Röntgenstrahlenröhre 1 und den Röntgenstrahlendetektor 2 zueinander gegenläufig zu bewegen, um eine Schrägdurchstrahlung zu bewirken, wie in Figur 2 gezeigt. Dadurch können im Rahmen eines Tomosyntheseverfahrens für dreidimensionale Schichtbildaufnahmen geeignete Querschnittsabbildungen gemacht werden. Die für das Tomosyntheseverfahren notwendige Abstandsmessung erfolgt bevorzugt mittels Laser-Triangulator.

Dadurch, daß während des Prüfprozesses die Leiterplatte nicht bewegt wird, wirken sich baugruppenspezifische Gewichte nicht in Form von Auf- und Abschwingen der Leiterplatte aus. Dadurch sind zum einen keine Wartezeiten zum Ausschwingen nötig und zum anderen können Abstandsmessungen zur Leiterplattenoberfläche mit erhöhter Genauigkeit durchgeführt werden. Diese erhöhte Genauigkeit der Abstandsmessungen wirkt sich bei dem dreidimensionalen Tomosyntheseverfahren besonders vorteilhaft aus.

Nach Beendigung des Prüfvorgangs wird die Leiterplatte 3 wieder so langsam aus der Untersuchungskammer herausgefahren, daß die während dieses Vorgangs wirkenden Kräfte keine Beeinträchtigungen der Lötstellen nach sich ziehen.

Gemäß der vorliegenden Erfindung kann ein zusätzlicher Mechanismus zur Verschiebung des Detektors in der Z-Richtung (parallel zur Oberflächennormale der Baugruppe) vorgesehen sein. Dadurch kann eine bauteilspezifische Anpassung der Objektauflösung erreicht werden. Dies führt bei sowohl der zwei- als auch der dreidimensionalen Inspektion zu einer Optimierung der erzielbaren Prüfgeschwindigkeit, da beispielsweise Baugruppen bzw. Bauteile mit einer groberen Lötverbindungsstruktur mit einem entsprechend höheren Flächendurchsatz geprüft werden können.

## Patentansprüche

1. Vorrichtung zur Inspektion von Testobjekten (3) mit
- einer Röntgenstrahlenröhre (1) mit einem im Vergleich zur horizontalen Ausdehnung des zu prüfenden Bereichs des Testobjekts kleinen Gesichtsfeld,
- einem Detektor (2) mit einem im Vergleich zur horizontalen Ausdehnung des zu prüfenden Bereichs des Testobjekts kleinen Gesichtsfeld,
**dadurch gekennzeichnet, daß**
die Vorrichtung derart gestaltet ist, daß das Testobjekt (3) während des Inspektionsvorgangs ortsfest positioniert ist, während die Röntgenstrahlenröhre (1) und der Detektor (2) zur Inspektion des gesamten zu prüfenden Bereichs des Testobjekts innerhalb einer x-y-Ebene verschiebbar angeordnet sind.

2. Vorrichtung nach Anspruch 1, **dadurch gekennzeichnet, daß** das Testobjekt (3) auf einer während der Inspektion des Testobjekts feststehenden Halterung befestigt ist.

3. Vorrichtung nach Anspruch 1 oder 2, weiter **gekennzeichnet durch** eine Recheneinheit, die mit dem Detektor (2) verbunden ist.

4. Vorrichtung nach Anspruch 3, weiter **gekennzeichnet durch** eine Auswerteeinheit, die mit der Recheneinheit verbunden ist.

5. Vorrichtung nach einem der Ansprüche 1 bis 4, **dadurch gekennzeichnet, daß** die Röntgenstrahlenröhre (1) eine Mikrofokusröhre mit einem Brennfleckdurchmesser von 10 bis 40 µm ist.

6. Vorrichtung nach einem der Ansprüche 1 bis 5, **dadurch gekennzeichnet, daß** der Detektor (2) ein auf einem Taper angeordneter CCD-Chip ist.

7. Vorrichtung nach einem der Ansprüche 1 bis 6, **dadurch gekennzeichnet, daß** sie zur zweidimensionalen Untersuchung von Testobjekten (3) geeignet ist.

8. Vorrichtung nach Anspruch 7, **dadurch gekennzeichnet, daß** sie zur dreidimensionalen Untersuchung von Testobjekten (3) geeignet ist.

9. Vorrichtung nach einem der Ansprüche 1 bis 8, **dadurch gekennzeichnet, daß** die Testobjekte jeweils Flachbaugruppen bzw. bestückte Leiterplatten sind.

10. Verwendung der Vorrichtung nach einem der Ansprüche 1 bis 9 zur Röntgen-Inspektion von Lötverbindungen auf Flachbaugruppen bzw. bestückten Leiterplatten.

11. Verwendung nach Anspruch 10 zur vollautomatischen 100%-Röntgen-Inspektion von Lötverbindungen auf Flachbaugruppen bzw. bestückten Leiterplatten.

12. Verwendung nach Anspruch 10, wenn auf Anspruch 4 rückbezogen, **dadurch gekennzeichnet, daß** der Bildauswerteeinheit im Lernmodus ein Satz von anzuwendenden Prüfalgorithmen übergeben wird und mit Hilfe dieser Algorithmen ein Merkmalsvektor für eine individuelle Lötstelle generiert wird, der mit den Vektoren dieser Lötstelle von weiteren Flachbaugruppen bzw. bestückten Leiterplatten optimiert wird, so daß der sich ergebende Merkmalsvektor eine fehlerfreie Lötstelle statistisch repräsentiert.

13. Verwendung nach Anspruch 12, **dadurch gekennzeichnet, daß** der Bildauswerteeinheit im Prüfmodus ein Pad-Bildpuffer, der Satz an Prüfalgorithmen und die eingelernten Merkmalsvektoren mit Toleranzen übergeben werden und zur Überprüfung einer Lötstelle die Korrelation zwischen den eingelernten Merkmalsvektoren mit Toleranzen und der zu überprüfenden Lötstelle bestimmt wird.

## Claims

1. Device for inspecting test objects (3) with
- an X-ray tube (1) with a small viewing field compared to the horizontal expanse of the area of the test object to be examined;
- a detector (2) with a small viewing field compared to the horizontal expanse of the area of the test object to be examined;
**characterised in that** the device is configured such that the test object (3) is fixedly positioned during the inspection process, whereas the X-ray tube (1) and the detector (2) are displaceably disposed within an x-y plane for inspection of the entire area of the test object to be examined.

2. Device according to Claim 1, **characterised in that** the test object (3) is fastened on a fixed mounting during the inspection of the test object.

3. Device according to Claim 1 or 2, further **characterised by** a calculating unit, which is connected to the detector (2).

4. Device according to Claim 3, further **characterised by** an evaluation unit, which is connected to the calculating unit.

5. Device according to one of Claims 1 to 4, **characterised in that** the X-ray tube (1) is a microfocus tube with a focal spot diameter of 10 to 40 µm.

6. Device according to one of Claims 1 to 5, **characterised in that** the detector (2) is a CCD chip disposed on a taper.

7. Device according to one of Claims 1 to 6, **characterised in that** it is suitable for the two-dimensional examination of test objects (3).

8. Device according to Claim 7, **characterised in that** it is suitable for the three-dimensional examination of test objects (3).

9. Device according to one of Claims 1 to 8, **characterised in that** the test objects respectively are flat assemblies or printed-board assemblies.

10. Use of the device according to one of Claims 1 to 9 for the X-ray inspection of soldering joints on flat assemblies or printed-board assemblies.

11. Use according to Claim 10 for the fully automatic 100% X-ray inspection of soldering joints on flat assemblies or printed-board assemblies.

12. Use according to Claim 11, when referred back to Claim 4, **characterised in that** a set of test algorithms to be applied is transferred to the image evaluation unit in learn mode and by means of these algorithms a feature vector is generated for an individual soldering joint, which is optimised with the vectors of this soldering joint of further flat assemblies or printed-board assemblies, so that the resulting feature vector statistically represents a fault-free soldering joint.

13. Use according to Claim 12, **characterised in that** a pad image buffer, the set of test algorithms and the learned feature vectors with tolerances are passed to the image evaluation unit in test mode and the correlation between the learned feature vectors with tolerances and the soldering joint to be examined is determined for examination of a soldering joint.

## Revendications

1. Dispositif de contrôle d'objet à tester (3) comportant
- un tube à rayons X (1) d'un petit champ de vision comparé à l'extension horizontale de la zone à vérifier de l'objet à tester,
- un détecteur (2) d'un petit champ de vision comparé à l'extension horizontale de la zone à vérifier de l'objet à tester,
**caractérisé en ce que**
le dispositif est constitué de manière telle que l'objet à tester (3) est positionné en un emplacement fixe pendant le processus de contrôle alors que le tube à rayons X (1) et le détecteur (2) sont disposés de manière mobile à l'intérieur d'un plan x, y pour le contrôle de la zone totale à vérifier de l'objet à tester.

2. Dispositif selon la revendication 1,
**caractérisé en ce que**
l'objet à tester (3) est fixé sur un support fixe pendant le contrôle de l'objet à tester.

3. Dispositif selon la revendication 1 ou 2,
**caractérisé par**
une unité de calcul qui est reliée avec un détecteur (2).

4. Dispositif selon la revendication 3,
**caractérisé par**
une unité d'exploitation qui est reliée avec l'unité de calcul.

5. Dispositif selon l'une quelconque des revendications 1 à 4,
**caractérisé en ce que**
le tube à rayons X (1) est un tube à micro-foyer d'un diamètre de tache focale de 10 à 40 µm.

6. Dispositif selon l'une quelconque des revendications 1 à 5,
**caractérisé en ce que**
le détecteur (2) est un circuit CCD disposé sur un Taper.

7. Dispositif selon l'une quelconque des revendications 1 à 6,
**caractérisé en ce qu'**
il est adapté à l'examen bidimensionnel d'objets à tester (3).

8. Dispositif selon la revendication 7,
**caractérisé en ce qu'**
il est adapté à l'examen tridimensionnel d'objets à tester (3).

9. Dispositif selon l'une quelconque des revendications 1 à 8,
**caractérisé en ce que**
les objets à tester sont chaque fois des modules plats ou des circuits imprimés équipés.

10. Utilisation du dispositif selon l'une quelconque des revendications 1 à 9, pour le contrôle par rayons X de liaisons soudées de modules plats ou de circuits imprimés équipés.

11. Utilisation selon la revendication 10, pour le contrôle intégralement automatique 100 % par rayons X de liaisons soudées de modules plats ou de circuits imprimés équipés.

12. Utilisation selon la revendication 10, lorsque référée à la revendication 4,
**caractérisée en ce que**
l'unité d'exploitation d'images en mode apprentissage reçoit un jeu d'algorithmes de contrôle à utiliser et, à l'aide de ces algorithmes, génère un vecteur caractéristique pour un emplacement individuel de soudure, qui est optimisé avec les vecteurs de cet emplacement de soudure d'autres modules plats ou circuits imprimés équipés, si bien que le vecteur caractéristique qui en résulte représente statistiquement un emplacement de soudures sans défauts.

13. Utilisation selon la revendication 12,
**caractérisée en ce que**
l'unité d'exploitation d'images, en mode contrôle reçoit un tampon image/pastille, le jeu d'algorithmes de contrôle et les vecteurs caractéristiques appris, avec des tolérances, et, pour le contrôle d'un emplacement de soudure, la corrélation entre les vecteurs caractéristiques appris, avec tolérances, et l'emplacement de soudure à contrôler est déterminée.
